# EUROPEAN PATENT APPLICATION

(11) **EP 2 730 415 A1**
(43) Date of publication of application: **14.05.2014**
(21) Application number: 13190929.3
(22) Date of filing: 30.10.2013
(51) Int. Cl.: B41J 2/14, B41J 2/16

(54) **Liquid ejecting head and liquid ejecting apparatus and actuator**

(30) Priority: 12.11.2012 JP 2012248755; 20.08.2013 JP 2013170799
(71) Applicant: Seiko Epson Corporation, Shinjuku-ku Tokyo (JP)
(72) Inventor: Yazaki, Shiro, Suwa-shi, Nagano 392-8502 (JP)
(74) Representative: Miller Sturt Kenyon

(57) **Abstract**

A first electrode is on a substrate, a piezoelectric layer is on the first electrode, and a second electrode is on the piezoelectric layer. The piezoelectric layer has an active section and an inactive section. The active section is located between the first electrode and the second electrode, and at least one of its ends is defined by the second electrode. The inactive section is thinner than the active section and extends outside the end of the second electrode that defines the active section. The active section and the inactive section are continuous with a slope therebetween. The second electrode has compressive stress.

## Description

### BACKGROUND

### 1. Technical Field

The present invention relates to a liquid ejecting head and a liquid ejecting apparatus that both eject droplets of liquid through deformation of piezoelectric elements and, in particular, relates to an actuator that has a piezoelectric element.

### 2. Related Art

A known liquid ejecting head ejects droplets of liquid through its nozzles by deforming piezoelectric elements (actuators) to change the pressure in the liquid in pressure chambers that communicate with the nozzles. A representative example is an ink jet recording head, which ejects droplets of ink.

A typical ink jet recording head has a flow channel substrate, and also has pressure chambers and actuators (piezoelectric elements) on either side of the flow channel substrate. The pressure chambers communicate with nozzle openings. The actuators operate to deform diaphragms and change the pressure in the pressure chambers. As a result, droplets of ink are ejected through the nozzles.

Each actuator is composed of a first electrode, a piezoelectric layer, and a second electrode all stacked on a diaphragm (e.g., see JP-A-2009-172878).

This type of actuator, i.e., the piezoelectric actuator, is disadvantageous in several ways. For example, applying voltage between the first electrode and the second electrode causes stress to concentrate at the boundary between two sections of the piezoelectric layer. One is an active section, where piezoelectric strain occurs, and the other is a piezoelectrically inactive section, where piezoelectric strain does not occur.

Furthermore, in a configuration where the components of each piezoelectric actuator, namely the first electrode, the piezoelectric layer, and the second electrode, extend beyond the edge of the corresponding pressure chamber, a greater stress concentration can occur in the section of the piezoelectric layer where piezoelectric strain occurs (active section). This type of stress concentration occurs at the edge of the pressure chamber, at which the actuator is divided into the portion facing the pressure chamber (flexible portion) and the portion extending outside the edge of the pressure chamber (inflexible portion) Stress concentration at this point may cause burnouts, cracks, and other sorts of damage to the piezoelectric layer.

Such problems are not unique to ink jet recording heads. Similar problems may also be encountered with liquid ejecting heads used with any kind of liquid other than ink.

### SUMMARY

An advantage of some aspects of the invention is that they provide a liquid ejecting head, a liquid ejecting apparatus, and an actuator that are all advantageous because of reduced damage to the piezoelectric layer.

An aspect of the invention provides a liquid ejecting head that has a substrate, a first electrode above the substrate, a piezoelectric layer above the first electrode, and a second electrode above the piezoelectric layer. The piezoelectric layer has an active section and an inactive section. The active section is located between the first electrode and the second electrode, and at least one of its ends is defined by the second electrode. The inactive section is thinner than the active section and extends outside the end of the second electrode that defines the active section. The active section and the inactive section are continuous with a slope therebetween. The second electrode has compressive stress.

In this aspect the internal stress in the second electrode is compressive stress so that the internal stress in the piezoelectric layer (tensile stress) is relaxed. As a result, the stress concentrating at the boundary between the active section and the inactive section is reduced. The slope between the active section and the inactive section also helps to reduce the stress concentration at the boundary between the active section and the inactive section, thereby limiting burnouts, cracks, and other sorts of damage associated with stress concentration.

Preferably, the second electrode has a first layer and a second layer. The first layer is on the piezoelectric layer side, and the second layer is opposite the piezoelectric layer with respect to the first layer and is made of a material different from the material that forms the first layer. This allows the piezoelectric layer to be heated after the first layer is formed (post-annealing). Post-annealing improves the piezoelectric properties of the piezoelectric layer.

It is also preferred that the first layer contains iridium oxide and titanium oxide and that the second layer contains iridium. This ensures excellent conductivity of the second electrode.

It is also preferred that the second electrode serves as a continuous common electrode for more than one active section. This eliminates the need for separate coatings such as protective films, thereby ensuring a sufficient amount of displacement and reducing costs.

It is also preferred that the second electrode has a thickness of 15 nm to 25 nm, both inclusive. This improves the amount of displacement of the active section.

Another aspect of the invention provides a liquid ejecting apparatus that has a liquid ejecting head according to the preceding aspect.

A liquid ejecting apparatus according to this aspect is of improved reliability because of reduced damage.

A different aspect of the invention provides an actuator that has a substrate, a first electrode above the substrate, a piezoelectric layer above the first electrode, and a second electrode above the piezoelectric layer. The piezoelectric layer has an active section and an inactive section. The active section is located between the first electrode and the second electrode, and at least one of its ends is defined by the second electrode. The inactive section is thinner than the active section and extends outside the end of the second electrode that defines the active section. The active section and the inactive section are continuous with a slope therebetween. The second electrode has compressive stress.

In this aspect the internal stress in the second electrode is compressive stress so that the internal stress in the piezoelectric layer (tensile stress) is relaxed. As a result, the stress concentrating at the boundary between the active section and the inactive section is reduced. The slope between the active section and the inactive section also helps to reduce the stress concentration at the boundary between the active section and the inactive section, thereby limiting burnouts, cracks, and other sorts of damage associated with stress concentration.

### BRIEF DESCRIPTION OF THE DRAWINGS

Embodiments of the invention will now be described by way of example only with reference to the accompanying drawings, wherein like numbers reference like elements.

Fig. 1 is an exploded perspective view of a recording head according to Embodiment 1 of the invention.

Figs. 2A and 2B are a plan view and a cross-sectional view, respectively, of the recording head according to Embodiment 1 of the invention.

Figs. 3A and 3B are enlarged cross-sectional views of some essential components of the recording head according to Embodiment 1 of the invention.

Figs. 4A to 4C, 5A to 5E, 6A to 6C, 7A and 7B, and 8A to 8C are cross-sectional diagrams illustrating a method for manufacturing a recording head according to Embodiment 1 of the invention.

Fig. 9 is a graph that shows the results of a test.

Fig. 10 is a schematic view of a liquid ejecting apparatus according to an embodiment of the invention.

### DESCRIPTION OF EXEMPLARY EMBODIMENTS

The following details some embodiments of the invention with reference to the accompanying drawings.

### Embodiment 1

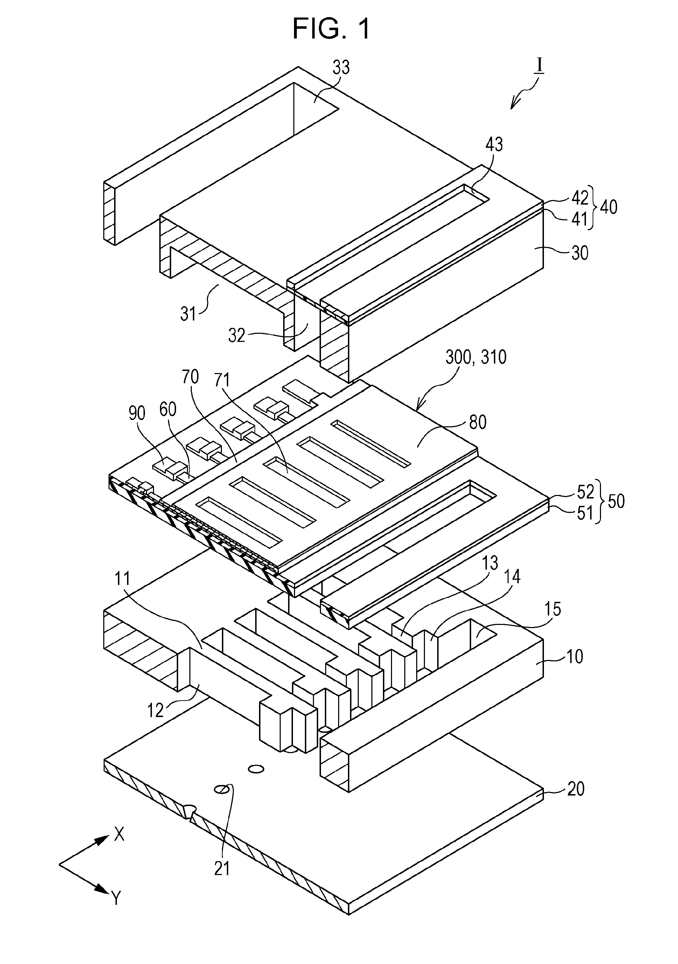

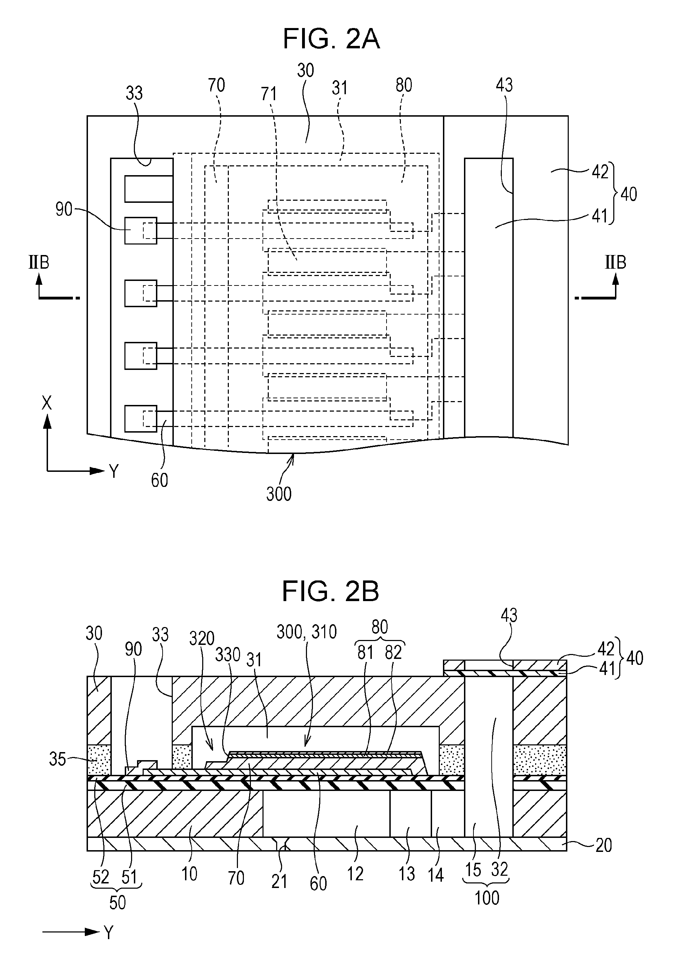

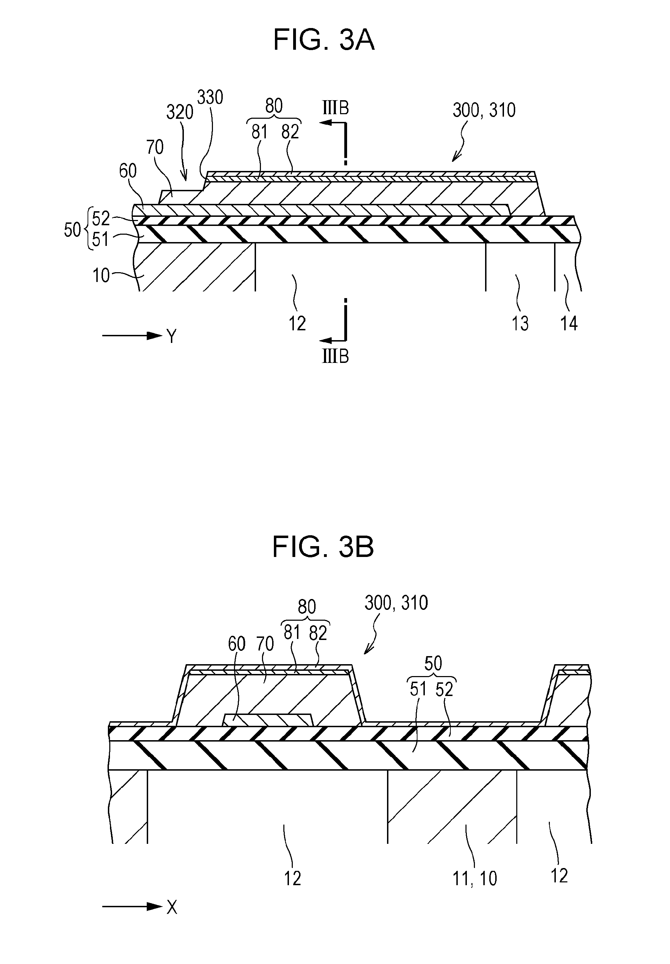

Fig. 1 is a perspective view of an ink jet recording head as an example of a liquid ejecting head according to Embodiment 1 of the invention. Figs. 2A and 2B are a plan view and a cross-sectional view, respectively, of the ink jet recording head. Figs. 3A and 3B are enlarged cross-sectional diagrams from Figs. 2A and 2B, illustrating some essential components.

As illustrated in these drawings, the ink jet recording head I, an example of a liquid ejecting head according to this embodiment, has a flow channel substrate 10 that has several pressure chambers 12. Defined by several walls 11, the pressure chambers 12 are arranged in the direction of the arrangement of several nozzle openings 21 for ejecting ink of the same color. This direction is hereinafter referred to as the direction of arrangement of the pressure chambers 12 or first direction X. The direction perpendicular to first direction X is hereinafter referred to as second direction Y.

The flow channel substrate 10 also has ink supply paths 13 and communicating paths 14 both defined by the walls 11. These components are located next to one longitudinal end of the pressure chambers 12, or in other words next to one end in second direction Y, the direction perpendicular to first direction X. The substrate also has a communicating space 15 as a component of a manifold 100, which serves as a common ink tank (liquid tank) for the pressure chambers 12, in the outside of the communicating paths 14 (opposite the pressure chambers 12 in second direction Y). The flow channel substrate 10 therefore has a flow channel formed by the pressure chambers 12, the ink supply paths 13, the communicating paths 14, and the communicating space 15.

A nozzle plate 20 drilled with nozzle openings 21 that communicate with the pressure chambers 12 is bonded using an adhesive agent, hot-melt film, or a similar material to one side of the flow channel substrate 10, or more specifically to the side on which the flow channel formed by the pressure chambers 12 and other components has openings. This means that the nozzle plate 20 has nozzle openings 21 arranged in first direction X.

A diaphragm 50 is provided on the other side of the flow channel substrate 10. The diaphragm 50 in this embodiment is composed of an elastic film 51 on the flow channel substrate 10 and an insulating film 52 on the elastic film 51. The pressure chambers 12 and the other flow channel components are created by anisotropically etching the flow channel substrate 10 from one side, and the diaphragm 50 (elastic film 51) is on the other side of the pressure chambers 12 and the other flow channel components.

Piezoelectric elements 300 are formed on the insulating film 52 and each have a first electrode 60, a piezoelectric layer 70, and a second electrode 80. The thickness of these layers is, for example, about 0.2 µm, about 1.0 µm, and about 0.05 µm, respectively. Each piezoelectric element 300 on the substrate (flow channel substrate 10) serves as an actuator in this embodiment.

The following describes the piezoelectric elements 300 as actuators in more detail with reference to Figs. 3A and 3B.

As illustrated in Figs. 2A and 2B, the first electrode 60, a component of the piezoelectric elements 300, is cut into pieces for the individual pressure chambers 12 and provides separate electrodes for the piezoelectric elements 300. Each piece of the first electrode 60 (hereinafter simply referred to as the first electrode 60) is narrower than the pressure chamber 12 in the first direction X of the pressure chamber 12. In other words, the ends of the first electrode 60 in the first direction X of the pressure chamber 12 are within the area facing the pressure chamber 12. On the other hand, the ends of the first electrode 60 in the second direction Y of the pressure chamber 12 are both beyond the edge of the pressure chamber 12. The entire first electrode 60 can be made of any metallic material. Examples of suitable materials include platinum (Pt) and iridium (Ir).

The piezoelectric layer 70 continuously extends in first direction X and has a predetermined width in second direction Y. The width of the piezoelectric layer 70 in second direction Y is larger than the length of the pressure chamber 12 in second direction Y. This means that the piezoelectric layer 70 extends beyond the edge of the pressure chamber 12 in the second direction Y of the pressure chamber 12.

One end of the piezoelectric layer 70 in the second direction Y of the pressure chamber 12 (the ink supply path side in this embodiment) is beyond the edge of the first electrode 60; the piezoelectric layer 70 covers the first electrode 60 at this end. The other end of the piezoelectric layer 70 in the second direction Y of the pressure chamber 12 is within the edge of the first electrode 60 (i.e., closer to the pressure chamber 12).

The end of the first electrode 60 located beyond the edge of the piezoelectric layer 70 is coupled to a lead electrode 90 made of gold (Au) or a similar material. Although not illustrated in the drawings, the lead electrode 90 serves as a terminal for coupling with wiring leading to a driver and other components.

The piezoelectric layer 70 also has depressions 71 facing the walls 11 (see depression 71 in Fig. 2A and the unreferenced depression in Fig. 3B). The width of each depression 71 in first direction X is substantially equal to or larger than the width of each wall 11 in first direction X. This ensures moderate rigidity of the diaphragm 50 in the portions facing the lateral ends of the pressure chambers 12 (the "arms" of the diaphragm 50), thereby allowing the piezoelectric elements 300 to be smoothly displaced.

The piezoelectric layer 70 can be a perovskite-structured crystal film (perovskite crystals) that is formed on the first electrode 60, made of a ferroelectric ceramic material, and can serve as an electromechanical transducer. Examples of materials that can be used to make the piezoelectric layer 70 include ferroelectric piezoelectric materials such as lead zirconate titanate (PZT) and their derivatives containing metal oxides such as niobium oxide, nickel oxide, and magnesium oxide. Specific examples include lead titanate (PbTiO₃), lead zirconate titanate (Pb(Zr, Ti)O₃), lead zirconate (PbZrO₃), lead lanthanum zirconate ((Pb, La)TiO₃), lead lanthanum zirconate titanate ((Pb, La)(Zr, Ti)O₃), and lead zirconium titanate magnesium niobate (Pb(Zr, Ti)(Mg, Nb)O₃). The piezoelectric layer 70 in this embodiment is made of lead zirconate titanate (PZT).

Besides piezoelectric materials containing lead (lead-based piezoelectrics), piezoelectric materials that contain no lead (lead-free piezoelectrics) can also be used to make the piezoelectric layer 70. Examples of lead-free piezoelectrics include the following: bismuth ferrite (BiFeO₃, abbreviated to BFO), barium titanate (BaTiO₃, BT), sodium potassium niobate ((K, Na)NbO₃, KNN), potassium sodium lithium niobate ((K, Na, Li)NbO₃), potassium sodium lithium niobate tantalate ((K, Na, Li)(Nb, Ta)O₃), bismuth potassium titanate ((Bi_{1/2}K_{1/2})TiO₃, BKT), bismuth sodium titanate ((Bi_{1/2}Na_{1/2})TiO₃, BNT), and bismuth manganite (BiMnO₃, BM); perovskite composite oxides containing bismuth, potassium, titanium, and iron (x[(BiₓK₁₋ₓ)TiO₃]-(1-x)[BiFeO₃]_{,} BKT-BF); and perovskite composite oxides containing bismuth, iron, barium, and titanium ((1-x)[BiFeO₃]-x[BaTiO₃], BFO-BT) and their derivatives further containing metals such as manganese, cobalt, and chromium ((1-x)[Bi(Fe_{1-y}M_{y})O₃]-x[BaTiO₃], M: Mn, Co, Cr, or a similar metal).

As is described in more detail hereinafter, various methods can be used to form the piezoelectric layer 70, including liquid-phase techniques such as the sol-gel process and MOD (metal-organic decomposition), and also PVD (physical vapor deposition) techniques (gas-phase processes) such as sputtering and laser abrasion. The piezoelectric layer 70 in this embodiment is so formed that the internal stress therein is tensile stress.

The second electrode 80 continuously extends in the first direction X of the pressure chamber 12 on the piezoelectric layer 70 and serves as a common electrode for the piezoelectric elements 300. The second electrode 80 in this embodiment has a first layer 81 on the piezoelectric layer 70 side and a second layer 82 opposite the piezoelectric layer 70 with respect to the first layer 81. As is described in more detail hereinafter, a typical way to form the first layer 81 is to deposit a coating of iridium on the piezoelectric layer 70, deposit a coating of titanium on the iridium coating, and then heat the coatings to oxidize them; the first layer 81 in this embodiment contains iridium oxide and titanium oxide. The iridium coating in the first layer 81 prevents excessive amounts of the constituents of the piezoelectric layer 70 from diffusing into the first layer 81 during the heating process, and also protects the piezoelectric layer 70 from contamination by the material that forms the titanium coating.

The titanium coating in the first layer 81 adsorbs excessive amounts of the constituents of the piezoelectric layer 70 from the surface (on the second electrode 80 side), e.g., an excess of lead on the surface of the piezoelectric layer 70 when the piezoelectric layer 70 contains lead, thereby improving the piezoelectric properties of the piezoelectric layer 70.

The second layer 82 of the second electrode 80 is made of iridium or a similar conductive material, and can also be a stack of coatings of titanium and iridium. The second layer 82 is thicker than the first layer 81 and has a sufficiently low electric resistance. The internal stress in a coating of iridium is compressive stress, and a coating of titanium has substantially no internal stress. The internal stress in the second electrode 80 in this embodiment is therefore compressive stress.

Either end of the second electrode 80 in the second direction Y of the pressure chamber 12 (the ink supply path side) is within the edge of the piezoelectric layer 70 (i.e., closer to the pressure chamber 12). In other words, either end of the piezoelectric layer 70 in second direction Y is beyond the edge of the second electrode 80.

Configured in such a way, each piezoelectric element 300 is displaced when voltage is applied between the first electrode 60 and the second electrode 80. In other words, applying voltage between these two electrodes induces piezoelectric strain on the piezoelectric layer 70 in the section where this layer is sandwiched between the first electrode 60 and the second electrode 80. The active section 310 is the section of the piezoelectric layer 70 in which this layer undergoes piezoelectric strain when voltage is applied between the two electrodes, whereas the inactive section 320 is the section where the piezoelectric layer 70 does not. The active section 310, in which the piezoelectric layer 70 undergoes piezoelectric strain, is flexible in the portion facing the pressure chamber 12 and inflexible in the portion extending outside the edge of the pressure chamber 12.

In this embodiment, the first electrode 60, the piezoelectric layer 70, and the second electrode 80 all extend beyond the edge of the pressure chamber 12 in the second direction Y of the pressure chamber 12. The active section 310 therefore also extends beyond the edge of the pressure chamber 12. The active section 310 is therefore flexible in the portion where the piezoelectric element 300 faces the pressure chamber 12, and is inflexible in the portion extending outside the edge of the pressure chamber 12.

As illustrated in Fig. 3A, the end of the active section 310 opposite the ink supply path 13 in second direction Y is defined by the second electrode 80 in this embodiment. Furthermore, this end of the active section 310 in second direction Y is beyond the area facing the pressure chamber 12, or in other words, in its inflexible portion.

The inactive section 320, the section the second electrode 80 does not reach, extends outside the active section 310 in second direction Y. In this embodiment the inactive section 320 is on the side opposite the ink supply paths 13. The inactive section 320 is thinner than the active section 310 in second direction Y. This means that a difference in height exists between the active section 310 and the inactive section 320 because of the difference in thickness. These different levels are connected by a slope 330, which is a surface inclined with respect to the direction perpendicular to the surface of the flow channel substrate 10 on which the piezoelectric element 300 exists (i.e., sloping in relation to the normal direction). The thickness of the active section 310 and the inactive section 320 is the thickness of the piezoelectric element 300 in the individual sections, i.e., the total thickness of the first electrode 60, the piezoelectric layer 70, and the second electrode 80 (where provided) in the direction of stacking.

Such a slope 330 between the active section 310 and the inactive section 320 is preferably at an angle of 10 to 45 degrees with respect to the surface of the active section 310 for some reasons. For example, increasing the angle of the slope 330 beyond 45 degrees and to near the vertical causes stress to concentrate at the corner between the slope 330 and the inactive section 320, resulting in cracks and other sorts of damage occurring at the corner between the slope 330 and the inactive section 320.

The difference in thickness Δt between the inactive section 320 and the active section 310 preferably satisfies the relation s ≤ Δt ≤ 2 x s, where s is the thickness of the second electrode 80. In this embodiment, the second electrode 80 is etched and this process scrapes the inactive section 320 as a result of over-etching; therefore, the thickness difference Δt is the difference in level between the surface of the active section 310 and the surface of the over-etched inactive section 320. It is preferred that this Δt is not less than the thickness s of the second electrode 80 and is not more than twice the thickness s of the second electrode 80.

Such a configuration, in which the difference in surface level Δt between the active section 310 and the inactive section 320 is equal to or more than the thickness s of the second electrode 80, helps to ensure that the entire inactive section 320 can be over-etched regardless of the in-plane distribution in the flow channel substrate 10. In more specific terms, even if the amount of over-etching (Δt) varies from area to area in the flow channel substrate 10 (or the flow channel substrate wafer 110 described in detail hereinafter), it is unlikely that any portion of the inactive section 320 remains not over-etched when the amount of over-etching is equal to or more than the thickness s of the second electrode 80. Setting the amount of over-etching (Δt) at less than the thickness s of the second electrode 80 can cause some portion of the inactive section 320 not to be over-etched. Any portion of the piezoelectric layer 70 left unetched means that the second electrode 80 has not been completely removed, and in such a case the edge of the active section 310 can be ambiguous.

Furthermore, setting the difference in surface level Δt between the active section 310 and the inactive section 320 at not more than twice the thickness s of the second electrode 80 helps to prevent stress from concentrating at the corner between the slope 330 and the surface of the inactive section 320, thereby reducing the damage associated with stress concentration at this corner. This means that too large a difference in surface level (Δt) between the active section 310 and the inactive section 320 can cause stress to concentrate at the corner between the slope 330 and the surface of the inactive section 320 and, therefore, result in cracks, burnouts, and other sorts of damage occurring at this corner.

As mentioned above, the internal stress in the second electrode 80 is compressive stress. The internal stress in the piezoelectric layer 70 is tensile stress, and the compressive stress as the internal stress in the second electrode 80 relaxes the tensile stress in the piezoelectric layer 70; in other words, the compressive stress in the second electrode 80 acts to reduce the tensile stress in the piezoelectric layer 70, thereby lowering the internal stress in the piezoelectric layer 70. Lowering the internal stress in the piezoelectric layer 70 limits burnouts, cracks, and other sorts of damage that occur at the boundary between the active section 310 and the inactive section 320 of the piezoelectric layer 70.

The boundary between the active section 310 and the inactive section 320 in this embodiment is inflexible. This means that the stress localized in the boundary between the active section 310 and the inactive section 320 remains concentrated even when the diaphragm 50 is deformed. In this embodiment, the second electrode 80, in which the internal stress is compressive stress, is provided to relax the internal stress in the piezoelectric layer 70 (tensile stress). This configuration allows the stress that occurs at the boundary between the active section 310 and the inactive section 320 to be released, which remains concentrated even when the diaphragm 50 is deformed, thereby limiting burnouts, cracks, and other sorts of damage to the piezoelectric layer 70 caused by the stress concentration at that point.

Incidentally, the end of the active section 310 on the ink supply path 13 side in second direction Y is located above the opening defined by features such as the ink supply path 13 and the communicating path 14. This means that at the end of the active section 310 on the ink supply path 13 side in second direction Y, the stress at the boundary between the active section 310 and the inactive section 320 is released when the diaphragm 50 is deformed. Thus, the piezoelectric layer 70 is unlikely to be damaged by burnouts or cracks at the end of the active section 310 on the ink supply path 13 side in second direction Y, even without a particular feature like the slope 330. It is also possible to form an inactive section 320 and a slope 330 at the end of the active section 310 on the ink supply path 13 side in second direction Y; this reliably limits burnouts, cracks, and other sorts of damage associated with the stress concentrating at the end of the active section 310 on the ink supply path 13 side in second direction Y.

The ends of the active section 310 in first direction X are defined by the ends of the first electrode 60 in first direction X, and the ends of the first electrode 60 in first direction X are within the area facing the pressure chamber 12. The active section 310 is therefore flexible at its ends in first direction X, and the stress that occurs at the boundary between the active section 310 and the inactive section 320 in first direction X is released when the diaphragm 50 is deformed. This embodiment therefore requires no slopes 330 to be made at the ends of the active section 310 of the piezoelectric layer 70 in first direction X. However, forming slopes 330 at the ends of the active section 310 in first direction X is effective in limiting burnouts, cracks, and other sorts of damage caused by the stress concentrating at the ends of the active section 310 in first direction X.

After such piezoelectric elements 300 are formed, a protective substrate 30 for protecting the piezoelectric elements 300 is bonded to the flow channel substrate 10 by using an adhesive agent 35 as illustrated in Fig. 1 and Figs. 2A and 2B. The protective substrate 30 has a piezoelectric element housing 31, which is a recess that defines a space to accommodate the piezoelectric elements 300. The protective substrate 30 also has a manifold portion 32 as a component of the manifold 100. The manifold portion 32 is formed through the entire thickness of the protective substrate 30 and along the direction of the width of the pressure chambers 12 and, as mentioned above, communicates with the communicating space 15 of the flow channel substrate 10. The protective substrate 30 also has a through-hole 33 formed through the entire thickness of the protective substrate 30. For each active section 310, the lead electrode 90 coupled to the first electrode 60 is exposed in the through-hole 33, and one end of wiring leading to a driver is coupled to the lead electrode 90 in the through-hole 33 (not illustrated).

A compliance substrate 40 that has a sealing film 41 and a stationary plate 42 is bonded to the protective substrate 30. The sealing film 41 is made of a low-rigidity flexible material, and the manifold portion 32 is sealed with the sealing film 41 on either side. The stationary plate 42 is made of a relatively hard material such as metal. The stationary plate 42 has an opening 43 formed through its entire thickness over the area facing the manifold 100. One side of the manifold 100 is therefore sealed with the flexible sealing film 41 only.

In such a configuration the inkjet recording head I according to this embodiment receives ink from an external ink source (not illustrated) via an ink inlet, fills the entire space from the manifold 100 to the nozzle openings 21 with the ink, and then, in response to recording signals transmitted from a driver, distributes voltage between respective first electrodes 60 for the individual pressure chambers 12 and the second electrode 80. This makes the piezoelectric elements 300 and the diaphragm 50 undergo flexural deformation. As a result, the pressure chambers 12 are pressurized and eject ink droplets through the nozzle openings 21.

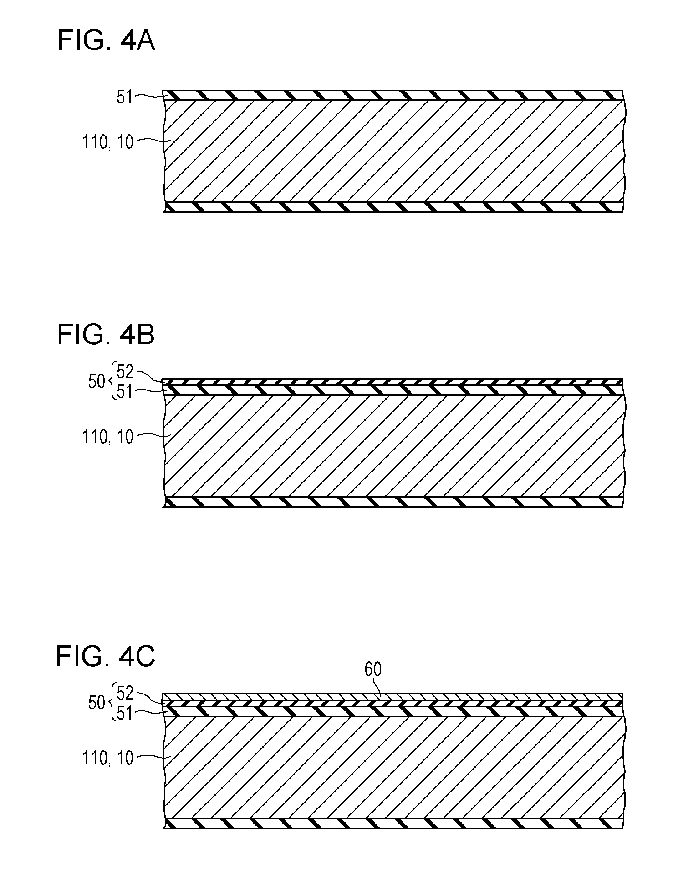

The following describes a method for manufacturing such an ink jet recording head according to this embodiment. Figs. 4A to 4C, 5A to 5E, 6A to 6C, 7A and 7B, and 8A to 8C are cross-sectional diagrams illustrating this method for manufacturing an inkjet recording head.

First, an elastic film 51 is formed on the surface of a flow channel substrate wafer 110 (a silicon wafer) as illustrated in Fig. 4A. In this embodiment, the flow channel substrate wafer 110 is thermally oxidized to form a silicon oxide coating as the elastic film 51. The elastic film 51 can also be made of materials other than silicon dioxide, including silicon nitride, polycrystalline silicon, and various organic compounds (e.g., polyimides and Parylene). Likewise, the elastic film 51 can be formed not only by thermal oxidation, but also by sputtering, CVD, spin coating, or any other suitable technique.

A coating of zirconium oxide is then deposited on the elastic film 51 to form an insulating film 52 as illustrated in Fig. 4B. The insulating film 52 can also be made of materials other than zirconium oxide, including titanium oxide (TiO₂), aluminum oxide (Al₂O₃), hafnium oxide (HfO₂), magnesium oxide (MgO), and lanthanum aluminate (LaAlO₃). Examples of methods that can be used to form the insulating film 52 include sputtering, CVD, and vacuum deposition. Although in this embodiment the elastic film 51 and the insulating film 52 form a diaphragm 50, it is also possible to form only either the elastic film 51 or the insulating film 52 and use it as the diaphragm 50.

The entire surface of the insulating film 52 is then coated with a first electrode 60 as illustrated in Fig. 4C. The first electrode 60 can be made of any material. When the piezoelectric layer 70 is made of lead zirconate titanate (PZT), it is desirable to use a material that changes its conductivity only to a limited extent when lead oxide penetrates. Thus, examples of suitable materials for the first electrode 60 include platinum and iridium. Examples of methods that can be used to form the first electrode 60 include sputtering and PVD (physical vapor deposition).

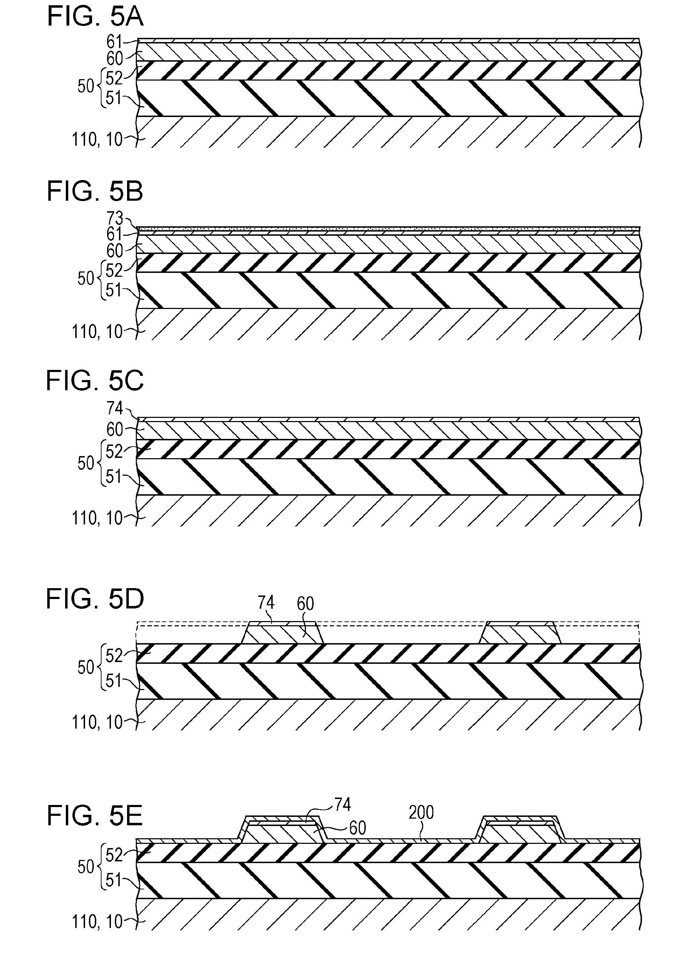

A coating of titanium (Ti) is then deposited on the first electrode 60 to form a seed crystal layer 61 as illustrated in Fig. 5A. Coating the first electrode 60 with the seed crystal layer 61 in this way ensures that in a later process the piezoelectric layer 70 can be formed on the seed crystal layer 61 spread on the first electrode 60 with the crystals constituting the piezoelectric layer 70 growing with a preferred orientation of (100), thereby making the piezoelectric layer 70 suitable for use as an electromechanical transducer. The seed crystal layer 61 serves as a seed to help the material for the piezoelectric layer 70 to crystallize and then, after the piezoelectric layer 70 is fired, diffuses into the piezoelectric layer 70. Although in this embodiment the seed crystal layer 61 is made of titanium (Ti), other materials can also be used as long as the obtained seed crystal layer 61 provides the core for the piezoelectric layer 70 to grow from while the piezoelectric layer 70 is formed in a later process. For example, the seed crystal layer 61 may be made of titanium oxide (TiO₂). Materials other than titanium or titanium oxide, such as lanthanum nickel oxide (LNO), can also be used. It is also possible that the seed crystal layer 61 is left between the first electrode 60 and the piezoelectric layer 70. The seed crystal layer 61 may be grown in the layer-by-layer or island mode.

The next process in this embodiment is to form a layer of lead zirconate titanate (PZT) as the piezoelectric layer 70. The piezoelectric layer 70 in this embodiment is obtained as a metal oxide film by the sol-gel process, in which a metal complex is dissolved or dispersed in a solvent to form sol, the sol is applied and the obtained coating is dried into gel, and the gel is fired at a high temperature to form the piezoelectric layer 70. Methods other than the sol-gel process can also be used to make the piezoelectric layer 70, including MOD (metal-organic deposition), and also PVD (physical vapor deposition) and techniques such as sputtering and laser abrasion; both liquid-phase techniques and gas-phase techniques can be used to form the piezoelectric layer 70.

The following is a specific example of how the piezoelectric layer 70 can be formed. First, as illustrated in Fig. 5B, a coating of a precursor material to PZT is deposited on the seed crystal layer 61 to form a precursor piezoelectric coating 73. More specifically, after the first electrode 60 (and the seed crystal layer 61) is formed, a sol (or a solution) that contains an appropriate metal complex is applied to the flow channel substrate wafer 110 (application stage), and the obtained precursor piezoelectric coating 73 is heated to a predetermined temperature and dried for a certain period of time (drying stage). In this embodiment, the precursor piezoelectric coating 73 can be dried by keeping it at a temperature of 170°C to 180°C for 8 to 30 minutes, for example.

The dried precursor piezoelectric coating 73 is then degreased by heating the dried coating at a predetermined temperature and keeping it at that temperature for a certain period of time (degreasing stage). In this embodiment, the dried precursor piezoelectric coating 73 can be degreased by heating the dried coating to a temperature in the order of 300°C to 400°C and keeping it at that temperature for about 10 to 30 minutes, for example. The term *degreasing,* as used herein, represents removing organic substances from the precursor piezoelectric coating 73 by decomposing them into smaller compounds such as NO₂, CO₂, and H₂O.

As illustrated in Fig. 5C, a piezoelectric film 74 is then formed by heating the degreased precursor piezoelectric coating 73 to a predetermined temperature and keeping it at that temperature for a certain period of time for crystallization (firing stage). At the firing stage the degreased precursor piezoelectric coating 73 is preferably heated to a temperature of 700°C or more, and the temperature is preferably increased at a rate of 50°C/sec or more. This ensures excellent characteristics of the piezoelectric film 74.

The seed crystal layer 61 on the first electrode 60 diffuses into the piezoelectric film 74. It is possible that the seed crystal layer 61 leaves titanium or titanium oxide residue between the first electrode 60 and the piezoelectric film 74.

Examples of heaters that can be used in such drying, degreasing, and firing stages include a hot plate and RTP (rapid thermal processing) systems, which use infrared lamps to heat the object.

After this first piezoelectric film 74 is formed on the first electrode 60, the first electrode 60 and the first piezoelectric film 74 are simultaneously patterned to have sloping sides as illustrated in Fig. 5D. Examples of methods that can be used to pattern the first electrode 60 and the first piezoelectric film 74 include dry etching processes such as ion milling.

Patterning the first electrode 60 before forming the first piezoelectric film 74, for example, would affect the characteristics of the surface of the first electrode 60 and other components on it, such as the seed crystal layer made of titanium or a similar material (not illustrated), because the process of patterning the first electrode 60 would involve photographic operations, ion milling, and ashing. Forming the piezoelectric film 74 on such an altered surface would result in insufficient crystallinity of the piezoelectric film 74. The poor crystallinity of the first piezoelectric film 74 would affect the crystals growing to form the second and subsequent piezoelectric films 74. As a result, the entire piezoelectric layer 70 would have insufficient crystallinity.

However, the approach of forming the first piezoelectric film 74 first and then patterning it simultaneously with the first electrode 60 affects the crystals growing to form the second and subsequent piezoelectric films 74 to a limited extent even if the patterning process forms an extremely thin altered layer on the top surface. This is because the first piezoelectric film 74 also provides the seed for crystals to grow well into the second and subsequent piezoelectric films 74, compared to seed crystals made of titanium or a similar material.

After the first piezoelectric film 74 and the first electrode 60 are patterned, an intermediate seed crystal layer 200 is formed to cover the insulating film 52, the sides of the first electrode 60, the sides of the first piezoelectric film 74, and the top of this piezoelectric film 74 as illustrated in Fig. 5E. Examples of materials that can be used to make the intermediate seed crystal layer 200 are similar to those for the seed crystal layer 61 and include titanium and lanthanum nickel oxide. The intermediate seed crystal layer 200 may be grown in the layer-by-layer or island mode, as with the seed crystal layer 61.

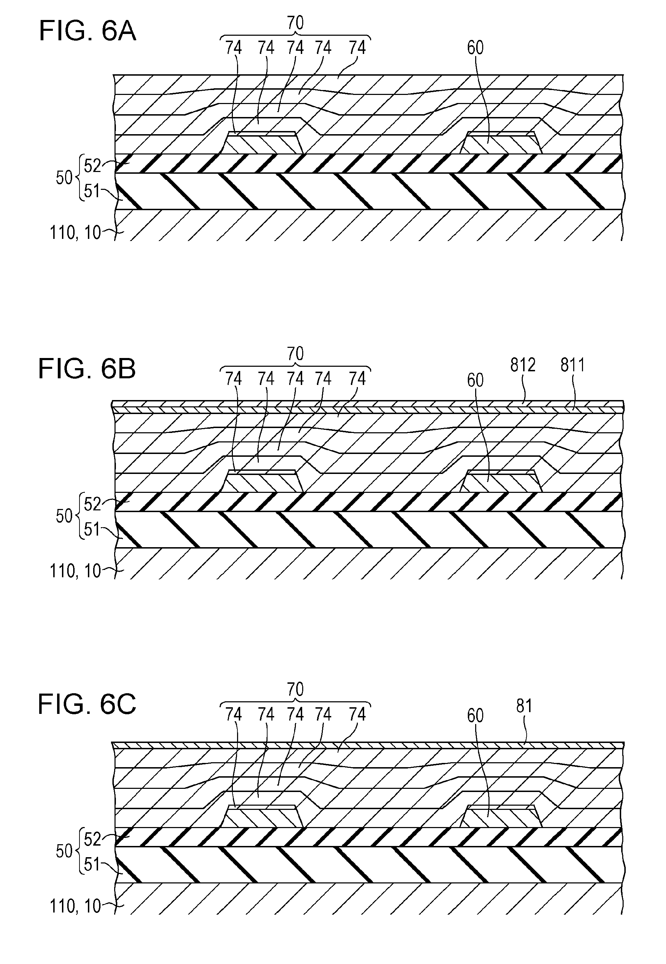

As illustrated in Fig. 6A, several piezoelectric films 74 are then stacked to form the piezoelectric layer 70 by repeating a piezoelectric film formation process as many times as required. The piezoelectric film formation process includes application, drying, degreasing, and firing stages as described above.

The second and subsequent piezoelectric films 74 continuously extend over the insulating film 52, the sides of the first electrode 60 and the first piezoelectric film 74, and the top of the first piezoelectric film 74. These regions are occupied by the intermediate seed crystal layer 200 before the second and subsequent piezoelectric films 74 are formed, and this intermediate seed crystal layer 200 ensures that the second and subsequent piezoelectric films 74 are made up of fine crystal grains growing with a preferred orientation of (100). The intermediate seed crystal layer 200 serves as a seed to help the material for the piezoelectric layer 70 to crystallize and then, after the piezoelectric layer 70 is fired, diffuses into the piezoelectric layer 70 completely or leaving some residue in an unchanged or oxidized form.

As illustrated in Fig. 6B, an iridium layer 811 that contains iridium is then deposited on the piezoelectric layer 70, and a titanium layer 812 that contains titanium is deposited on the iridium layer 811. The iridium layer 811 and the titanium layer 812 can be formed by sputtering or CVD, for example.

The piezoelectric layer 70 is then heated once again, with the iridium layer 811 and the titanium layer 812 thereon as illustrated in Fig. 6C (post-annealing). Although forming layers such as the iridium layer 811 on the second electrode 80 side of the piezoelectric layer 70 can cause damage, such a post-annealing process repairs the damage to the piezoelectric layer 70 and improves the piezoelectric properties of the piezoelectric layer 70. Furthermore, when the piezoelectric layer 70 contains lead as in this embodiment, post-annealing also transfers an excess of lead existing on the second electrode 80 side of the piezoelectric layer 70 onto the iridium layer 811 and the titanium layer 812, thereby limiting the negative impact the surplus lead has on the piezoelectric properties of the piezoelectric layer 70.

Post-annealing also turns the iridium layer 811 and the titanium layer 812 into a first layer 81 that contains iridium oxide and titanium oxide. The first layer 81 may be obtained with an excess of lead on its surface as mentioned above.

The post-annealing temperature is preferably within -10°C/+50°C from the temperature used in the firing stage to form the piezoelectric films 74 (i.e., the temperature to which the precursor piezoelectric coatings 73 are heated to crystallize).

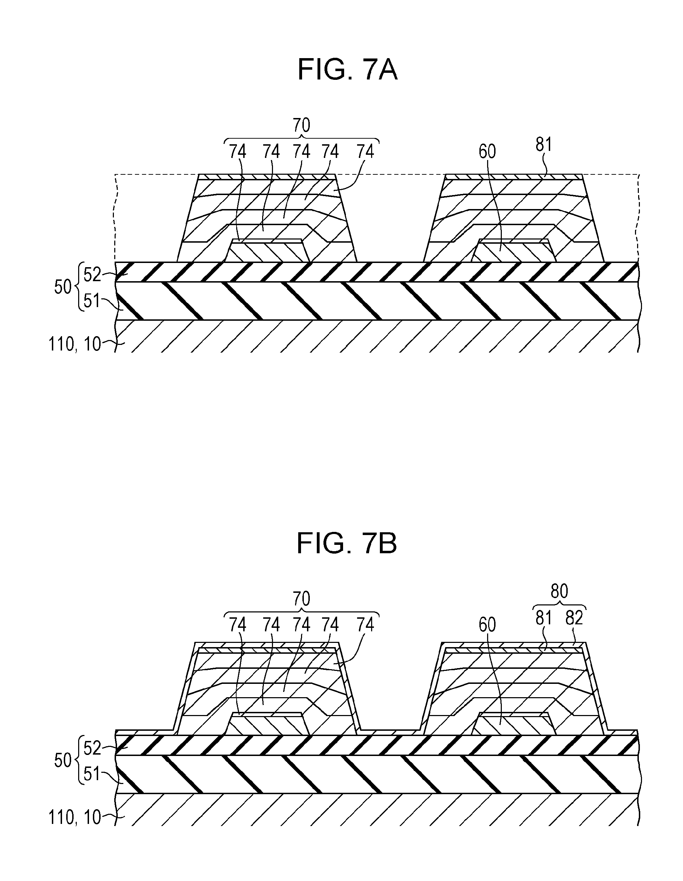

The first layer 81 and the piezoelectric layer 70 are then patterned to correspond to pressure chambers 12 as illustrated in Fig. 7A. In this embodiment these layers are patterned by photolithography, or more specifically by placing a patterned mask (not illustrated) on the first layer 81 and etching the piezoelectric layer 70 through the mask. Examples of methods that can be used to pattern the piezoelectric layer 70 include dry etching processes such as reactive ion etching and ion milling.

As illustrated in Fig. 7B, a layer of iridium (Ir) or a similar material is then deposited to form a second electrode 80 that covers the first layer 81, the sides of the patterned piezoelectric layer 70, and the insulating film 52, and the second electrode 80 is patterned. This process forms active sections 310 and inactive sections 320 and etches away some of the piezoelectric layer 70 in the direction of thickness to make slopes 330 (see Figs. 3A and 3B).

Lead electrodes 90 are then formed and patterned, although not illustrated (see Figs. 2A and 2B).

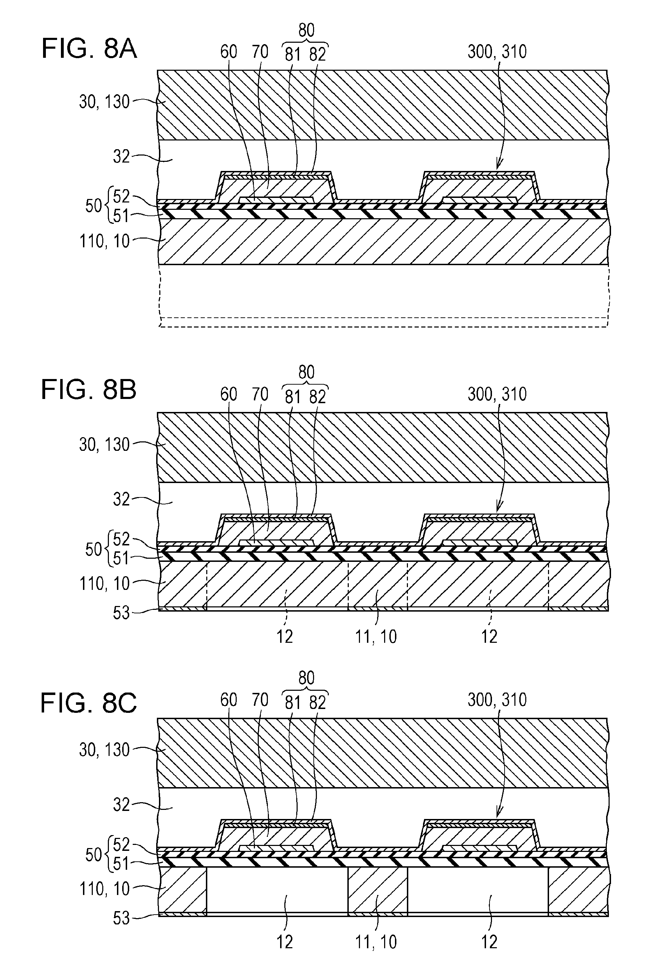

As illustrated in Fig. 8A, a protective substrate wafer 130 (a silicon wafer) as the base for several protective substrates 30 is then bonded using an adhesive agent 35 to the piezoelectric element 300 side of the flow channel substrate wafer 110, and the flow channel substrate wafer 110 is reduced in thickness.

A mask coating 53 is then formed and patterned on the flow channel substrate wafer 110 as illustrated in Fig. 8B. The flow channel substrate wafer 110 is then anisotropically etched with an alkali such as a KOH solution (wet etching) through the mask coating 53 as illustrated in Fig. 8C. This process forms the pressure chambers 12 for the individual piezoelectric elements 300 along with ink supply paths 13, communicating paths 14, a communicating space 15, and other features.

The flow channel substrate wafer 110 and the protective substrate wafer 130 are then trimmed by cutting off their unnecessary edge by dicing or a similar technique. A nozzle plate 20 drilled with nozzle openings 21 is then bonded to the surface of the flow channel substrate wafer 110 opposite the protective substrate wafer 130, and compliance substrates 40 are bonded to the protective substrate wafer 130. The entire structure including the flow channel substrate wafer 110 and all other components bonded thereto is divided into equal-sized chips each composed of one flow channel substrate 10 and other components like that illustrated in Fig. 1. In this way, ink jet recording heads according to this embodiment are obtained. Examples 1 to 5

A piezoelectric element 300 was prepared by a method similar to that according to Embodiment 1. The thickness of some layers was as follows: the elastic film 51, 1.3 to 1.4 µm; the insulating film 52, 0.3 to 0.4 µm; the first electrode 60, 0.1 to 0.2 µm; the active section 310 of the piezoelectric layer 70, 1 to 2 µm. The thickness of the second electrode 80 ranged from 15 nm to 25 nm; the thickness of the second electrode 80 was increased from 15 nm to 25 nm in 2.5-nm increments for piezoelectric elements 300 of Examples 1 to 5 in this embodiment.

The pressure chamber 12 was formed with a rectangular opening on the piezoelectric element 300 side, measuring 70 µm wide in first direction X and 360 µm long in second direction Y.

The piezoelectric element 300 was formed with a slope 330 similar to that described in Embodiment 1.

For the thickness of the second electrode 80, a tolerance of about ±10% from the specified value was allowed.

### Comparative Examples 1 to 3

For comparison purposes, piezoelectric elements 300 of Comparative Examples 1 to 3 were prepared with layer thickness ranges similar to those in Examples 1 to 5, except that the thickness of the second electrode 80 was changed to 27.5 nm, 30 nm, and 50 nm, respectively. The shape, dimensions, and other characteristics of the pressure chamber 12 was similar to that in Examples 1 to 5.

### Testing

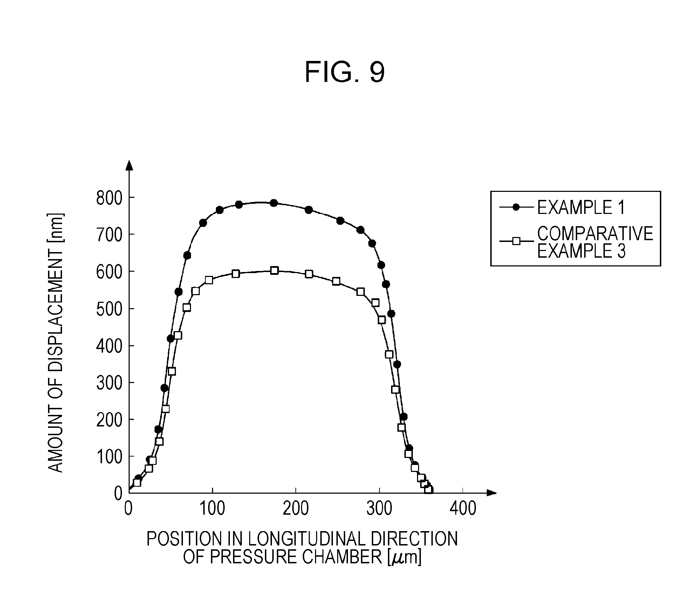

The piezoelectric elements 300 of Examples 1 to 5 and the piezoelectric elements 300 of Comparative Examples 1 to 3 were activated, and the amount of displacement was measured. Rectangular voltage pulses (0 to 35 V) were applied to each piezoelectric element 300, and a laser Doppler displacement meter was used to measure the amount of displacement. The measurements were made at several points along the long-side (longitudinal) direction of the pressure chamber 12. Fig. 9 shows measurements from Example 1 and Comparative Example 3. Table 1 presents measurements from Examples 1 to 5 and Comparative Examples 1 to 3 along with the percentage of the improved displacement of Examples 1 to 5 and Comparative Examples 1 and 2 compared to Comparative Example 3.

**Table 1**

| Thickness of the second electrode (nm) | 15 | 17.5 | 20 | 22.5 | 25 | 27.5 | 30 | 50 |
|---|---|---|---|---|---|---|---|---|
| Displacement (µm) | 786 | 780 | 775 | 762 | 750 | 726 | 690 | 600 |
| Improvement (%) | 31 | 30 | 29 | 27 | 25 | 21 | 15 | - |

These results indicate that the piezoelectric elements 300 of Examples 1 to 5, in which the second electrode 80 had a thickness of 15 nm to 25 nm, both inclusive, exhibited a 25% to approximately 30% improvement in the amount of displacement compared to that of Comparative Example 3, in which the thickness of the second electrode 80 was 50 nm.

The smallest thickness of the second electrode 80 tested was 15 nm so that the electrode was sufficiently reliable. In other words, the test did not include any second electrode 80 thinner than 15 nm because reducing the thickness of the second electrode 80 to less than 15 nm could have caused reliability issues.

Among the piezoelectric elements 300 of Examples 1 to 5, in which the second electrode 80 had a thickness of 15 nm to 25 nm, both inclusive, the percentage of the improved displacement compared to Comparative Example 3 varied between examples by only 1% to 2%. When the piezoelectric element 300 of Example 5 (the 25-nm thick second electrode 80) is compared to that of Comparative Example 1 (the 27.5-nm thick second electrode 80), however, the difference in the percentage of the improved displacement was 4%, exceeding the 1% to 2% among Examples 1 to 5. A more significant drop was observed in the percentage of the improved displacement between Comparative Examples 1 and 2. These results suggest that the displacement of piezoelectric elements 300 according to this embodiment is effectively improved when the second electrode 80 has a thickness of 15 nm to 25 nm, both inclusive.

Therefore the thinner the second electrode 80 is, the more improved the displacement of the piezoelectric element 300 is. In Embodiment 1, a slope 330 is formed between the active section 310 and the inactive section 320, and the second electrode 80 has compressive stress; these features reduce the internal stress in the piezoelectric layer 70 and limit the stress that concentrates at the boundary between the active section 310 and the inactive section 320. This approach is effective in limiting the damage caused by stress concentration even when the second electrode 80 is reduced in thickness to improve the displacement of the piezoelectric element 300. Without the slope 330, damage would be likely to occur to the piezoelectric element 300 in association with stress concentration, and trying to improve the displacement of the piezoelectric element 300 would make such damage more likely to occur because of the increased overall stress.

### Other embodiments

The foregoing is an embodiment of an aspect of the invention and is not the only possible basic structure of that aspect of the invention.

For example, although in Embodiment 1 the active sections 310 share a continuous piezoelectric layer 70, it is possible to divide the piezoelectric layer 70 into several pieces for the individual active sections 310. Likewise, although in Embodiment 1 the second electrode 80 serves as a common electrode for more than one active section 310 and the first electrode 60 provides separate electrodes for the individual active sections 310, this is not the only choice. For example, it is possible that the first electrode 60 serves as a common electrode for more than one active section 310 and the second electrode 80 provides separate electrodes for the individual active sections 310. Such a configuration, in which the first electrode 60 serves as a common electrode for several active sections 310, allows, for example, the elastic film 51 and the insulating film 55 to be omitted and the first electrode 60 itself to work as a diaphragm because in such a configuration the first electrode 60 as a whole is shared by these active sections 310. It is also possible that each piezoelectric element 300 substantially serves as a diaphragm, regardless of whether the first electrode 60 provides separate electrodes as in Embodiment 1 or the first electrode 60 serves as a common electrode. When the first electrode 60 is formed directly on the flow channel substrate 10, however, it is preferred to protect the first electrode 60 with an insulating protective film or a similar material to prevent electricity from flowing from the first electrode 60 to the ink. When it is herein stated that the first electrode 60 is formed on the substrate (flow channel substrate 10), therefore, it means that the electrode can be in direct contact with the substrate or with any other component therebeneath (i.e., the electrode can be above the substrate).

Furthermore, although in Embodiment 1 the second electrode 80 is a stack of a first layer 81 and a second layer 82, this is not the only possible structure of this electrode; the second electrode 80 may be a single layer or a stack of three or more layers.

In Embodiment 1 the piezoelectric films 74 are produced by applying a sol to form a precursor piezoelectric coating 73, drying the formed coating, degreasing the dried coating, and then firing the degreased coating. However, this is not the only way of producing these films. For example, it is possible to form the piezoelectric films 74 by carrying out several times (e.g., twice) the cycle of applying the sol, drying the precursor piezoelectric coating 73, and degreasing the dried coating, and after this subsequently firing the degreased coatings.

The pressure chambers 12 may have any shape. For example, the opening each pressure chamber 12 has on the piezoelectric element 300 side can be a quadrilateral such as a rectangle and a parallelogram, and can even have a polygonal shape with less than or more than four sides.

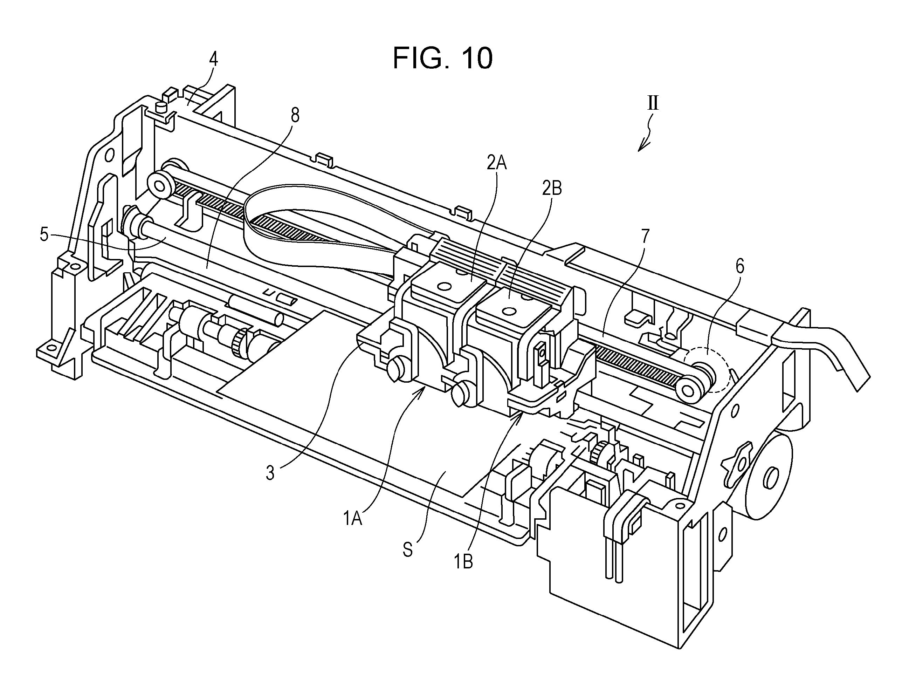

As illustrated in Fig. 10, the ink jet recording head I can be installed in an ink jet recording apparatus II, for example. The recording head units 1A and 1B hold ink jet recording heads I and are equipped with detachable ink supply cartridges 2A and 2B. The carriage 3 for the recording head units 1A and 1B can move along a carriage shaft 5 installed in the main body 4. The recording head units 1A and 1B eject a black ink composition and a color ink composition, for example.

Driving force generated by a motor 6 is transmitted through gears (not illustrated) and a timing belt 7 to the carriage 3. As a result, the carriage 3 and the recording head units 1A and 1B supported thereby move along the carriage shaft 5. The main body 4 also has a platen 8 that extends along the carriage shaft 5; a feeder such as a set of rollers (not illustrated) feeds a recording sheet S (a recording medium such as paper), which is then transported by the platen 8.

An aspect of the invention limits, as described above, damage to the piezoelectric elements 300 used in the ink jet recording heads I and ensures uniform ejection properties, thereby improving the print quality and the durability of the ink jet recording apparatus II.

Although in the illustrated ink jet recording apparatus II the ink jet recording heads I move on the carriage 3 in the primary scanning direction, this is not the only possible configuration. For example, the ink jet recording apparatus II can be a line-head recording apparatus, in which the ink jet recording heads I remain in fixed positions and the recording sheet S (a recording medium such as paper) moves in the secondary scanning direction.

The ink jet recording head described in Embodiment 1 is an example of a liquid ejecting head according to an aspect of the invention, and this aspect of the invention can also be applied to other liquid ejecting heads, such as recording heads for printers and other kinds of image recording apparatus, colorant ejecting heads for manufacturing color filters for liquid crystal displays and other kinds of displays, electrode material ejecting heads for forming electrodes for organic EL displays, FEDs (field emission displays), and other kinds of displays, and bioorganic substance ejecting heads for manufacturing biochips.

Besides such liquid ejecting heads (ink jet recording heads), another aspect of the invention can be applied to actuators for all kinds of apparatus. Actuators according to an aspect of the invention can be used in sensors, for example.

The foregoing description has been given by way of example only and it will be appreciated by a person skilled in the art that modifications can be made without departing from the scope of the present invention.

## Claims

1. An actuator (I) comprising:
a substrate (10);
a first electrode (60) above the substrate;
a piezoelectric layer (70) above the first electrode; and
a second electrode (80) above the piezoelectric layer, wherein:
the piezoelectric layer (70) has an active section (310) and an inactive section (320), the active section being located between the first electrode (70) and the second electrode (80) and at least one end of the active section being defined by the second electrode (80), and the inactive section being thinner than the active section and extending outside the end of the second electrode defining the active section;
the active section and the inactive section are continuous with a slope (330) therebetween; and
the second electrode (80) has compressive stress.

2. The actuator according to Claim 1, wherein the second electrode (80) has a first layer (81) and a second layer (82), the first layer being on a piezoelectric layer (70) side, and the second layer being opposite the piezoelectric layer with respect to the first layer and made of a material different from a material forming the first layer.

3. The actuator according to Claim 2, wherein the first layer (81) contains iridium oxide and titanium oxide, and the second layer (82) contains iridium.

4. The actuator according to any one of the preceding claims, wherein the second electrode (80)_serves as a continuous common electrode for more than one active section.

5. The actuator according to Claim 4, wherein the second electrode has a thickness of 15 nm to 25 nm, both inclusive.

6. A liquid ejecting head comprising an actuator according to any one of the preceding claims.

7. A liquid ejecting apparatus (II) comprising the liquid ejecting head (I) according to Claim6.
